# EUROPÄISCHE PATENTANMELDUNG

(11) **EP 0 582 724 A1**
(43) Veröffentlichungstag der Anmeldung: **16.02.1994**
(21) Anmeldenummer: 92113281.7
(22) Anmeldetag: 04.08.1992
(51) Int. Cl.: H01L 21/90, H01L 21/316

(54) **Verfahren zur lokal und global planarisierenden CVD-Abscheidung von SiO2-Schichten auf strukturierten Siliziumsubstraten**

(71) Anmelder: SIEMENS AKTIENGESELLSCHAFT, D-80333 München (DE)
(72) Erfinder: Hieber, Konrad, Dr. Dipl.-Phys., W-8011 Neukeferloh (DE); v. Tomkewitsch, Jasper, Dipl.-Phys., W-8012 Ottobrunn (DE); Spindler, Oswald, Dr. rer. nat., W-8011 Vaterstetten (DE); Treichel, Helmuth, Dipl.-Ing., W-8900 Augsburg (DE); Gabric, Zvonimir, W-8011 Zorneding (DE); Gschwandtner, Alexander, Dr. Phil., W-8000 München 21 (DE)

(57) **Zusammenfassung**

Bei der ozonaktivierten Abscheidung von Isolationsschichten können auf unterschiedlich beschaffenen Oberflächen unterschiedliche Aufwachsraten erzielt werden. Sind die auf unterschiedlichem Niveau liegenden Oberflächen der strukturierten Siliziumsubstrate derart unterschiedlich beschaffen bzw. werden gezielt so verändert, daß die SiO₂-Isolationsschicht (4, 5) auf den höherliegenden Oberflächen langsamer als auf den tieferliegenden aufwächst und wird so lange abgeschieden, bis die Oberflächen der schnellwachsenden (5) und der langsamwachsenden (4) Schichtbereiche eine stufenlose, planare Ebene bilden, wird eine lokale und globale Planarisierung erreicht.

## Beschreibung

Die Erfindung betrifft ein verfahren zur lokal und global planarisierenden CVD (Chemical-Vapour Deposition)-Abscheidung von SiO₂-Schichten auf strukturierten Siliziumsubstraten. Die Erfindung betrifft insbesondere die Abscheidung planarer SiO₂-Schichten, die als Isolierschichten zwischen den einzelnen Ebenen einer Mehrlagenverdrahtung bei höchstintegrierten Halbleiterschaltungen dienen.

Am Ende des Fertigungsprozesses mikroelektronischer Schaltungen müssen alle aktiven und passiven Schaltungselemente durch metallische, meistens aus Aluminium bestehende Leiterbahnen miteinander verbunden werden.
Die Leiterbahnen werden dabei durch ein Trockenätzverfahran aus einer zunächst ganzflächig aufgebrachten Schicht geätzt. Bedingt durch den mit immer höherer Integration immer geringer werdenden Abstand der einzelnen Elemente - bis hinab zu 0,3 µm bei der 64 Mbit-Speicher-Generation - und der Notwendigkeit, die Elemente unabhängig von ihrer Lage auf der Halbleiterschaltung miteinander zu verbinden, wird zunehmend, insbesondere bei Logik-Chips, eine in mehreren Ebenen übereinander angeordnete Verdrahtung gewählt. Diese Verdrahtungsebenen müssen durch Einführung von Isolationsschichten, auch dielektrische Zwischenschichten genannt, voneinander getrennt werden.

Infolge der zunehmenden Komplexität gleicht die Oberfläche jeder Verdrahtungsebene vor dem Aufbringen der Isolationsschichten immer mehr einem ausgeprägtem Gebirge.

Dies hat erhebliche Probleme bei der Abscheidung der Isolationsschichten und bei der anschließenden Lithographie (Erzeugung von Kontaktlöchern) zur Folge. Es werden deshalb Planarisierungsprozesse eingesetzt, um die durch die darunterliegenden Strukturen bedingten Unebenheiten durch die SiO₂-Schicht auszugleichen. Dabei treten zwei grundsätzliche Problemkreise auf:
Bekanntlich geht in der Lithographie jede im Zuge der Miniaturisierung erforderliche Erhöhung der Auflösung mit einer geringer werdenden Tiefenschärfe einher. Das Problem der bei der Submikrometerlithographie von vorneherein geringen zur Verfügung stehenden Tiefenschärfe, die durch Faktoren wie die Unebenheit der Scheibenoberfläche selbst noch reduziert wird, stellt sich bei der Mehrlagenverdrahtung im besonderen Maße. Es ist deshalb notwendig, die durch die Strukturierung der Metallisierungsebenen entstehenden Höhenunterschiede möglichst vollständig wieder auszugleichen, d. h. einen möglichst hohen Planarisierungsgrad zu erreichen.

Andererseits kommen infolge der willkürlichen elektrischen Kontaktierung der Bauelemente untereinander Leiterbahnabstände vom Submikrometerbereich bis zum Millimeterbereich in den einzelnen Verdrahtungsebenen vor. Deshalb ist ein nur lokal, d. h. in Bereiche ≦ ca. 1,5 µm zufriedenstellendes Planarisierungsverfahren unzureichend, da mit ≧ ca. 20 µm werdendem Abstand zwischen zwei erhabenen Strukturen die Tendenz wächst, daß darüber abgeschiedene SiO₂- , oder auch Photolack-Schichten diesen breiten Bereich nicht vollständig auffüllen. Diese zunehmende Tendenz zum "Absacken" vermindert natürlich den globalen Planarisierungsgrad.

Zusammengefaßt sind demnach die Schwierigkeiten bei der Planarisierung des Dielektrikums darin zu sehen, daß einerseits sehr kleine Leiterbahnabstände lunkerfrei aufgefüllt werden müssen, damit darüberführende Leiterbahnen nicht unterbrochen werden und daß gleichzeitig - auch bei großen Leiterbahnabständen - die Höhenunterschiede gut genug ausgeglichen werden müssen, um für die darüberführende Verdrahtungsebene eine Lithographie für Submikrometer-Leiterbahnen zu ermöglichen.

Zum Stand der Planarisierungstechnik wird auf D. Widmann et al, "Technologie hochintegrierter Schaltungen", Springer-Verlag, 1988, insbesondere auf Abschnitt 3.5.5, hingewiesen. Dort wird die Verwendung von Photolack als planarisierende Hilfsschicht diskutiert, wobei im Idealfall die planare Oberfläche des Lackes mittels einer Rückätztechnik auf die SiO₂-Schicht übertragen wird. Bei gebräuchlichen Schichtdicken des Lackes von ca. 2 µm liegt die Reichweite der Photolackplanarisierung im 10 µm Bereich. Dies bedeutet, daß bei größeren Abständen zwischen den erhabenen Strukturen doch wieder die bereits diskutierte, unerwünschte Absenkung eintritt, der globale Planarisierungsgrad sich mithin verschlechtert. Ebenfalls erwähnt bei Widmann et al ist die Methode der Planarisierung mittels Spin-on-Glas (SOG); der erreichbare Planarisierungsgrad ist mit dem von Photolack vergleichbar.

Auch neuere Planarisierungsverfahren, die beispielsweise besonders niederviskose Lacke verwenden, oder das CMP-Verfahren (Chemical Mechanical Polishing) arbeiten spätestens beim Übergang zu größeren Abständen von einigen 100 µm immer weniger zufriedenstellend.

Alle oben beschriebenen Planarisierungsverfahren sind struktur-, d. h. abstandsabhängig und besitzen daher nur eine begrenzte Planarisierungsreichweite. Aus dem Artikel von T.H. Daubenspeck et al, J. Electrochem. Soc. Vol. 138, No. 2 (1991), ist jedoch auch ein Verfahren zur Erzeugung von vollständig planarisierten Dielektrika bekannt, das zur Auffüllung ausgedehnter Bereiche, die nicht von der Metallisierung bedeckt sind, sogenannte Dummystrukturen verwendet. Diese Dummystrukturen haben dieselbe Dicke wie die Metallisierung. Beim bekannten Verfahren müssen lokale Niveauschwankungen, die durch die Ätzung der Dummystrukturen entstehen, anschließend entweder durch Photolack planarisiert werden, oder durch chemisch-mechanisches Polieren ausgeglichen werden. Die künstlichen, von der Schaltung her eigentlich nicht gebrauchten Aluminium-Strukturen haben außerdem den Nachteil, daß Koppelkapazitäten entstehen können. Darüberhinaus ist dieses Verfahren mit sehr großem Aufwand verbunden und generell nur für Chips mit regelmäßigen Strukturen geeignet.

Die denkbare Möglichkeit, durch Verwendung eines stark oberflächenkontrollierten Beschichtungsprozesses, eine Planarisierung zu erzielen, führt nur hinsichtlich der Auffüllung enger Strukturen (Gräben, Sacklöcher) zum Erfolg:
Durch die Wahl des Metallisierungsmaterials (Aluminium, Kupfer) ist der Temperaturbereich der Abscheide- bzw. Planarisierungsverfahren auf < 450 °C beschränkt. Die herkömmliche CVD-Abscheidung einer SiO₂-Schicht mit TEOS (Tetra-Ethyl-Ortho-Silikat) als Ausgangssubstanz (Prekursor) bei ca. 700 °C muß deshalb modifiziert werden. Da Plasmaoxidschichten wegen ihrer nur mittelguten Konformität nicht in Frage kommen, wurden CVD-Verfahren entwickelt, bei denen die Abscheidetemperatur durch Zugabe von Ozon gesenkt wird. Da der Zerfall und der chemische Angriff des Ozons an der Substratoberfläche stattfindet, gelingt es mit TEOS als Ausgangssubstanz bei mit Atmosphärendruck durchgeführten CVD-Abscheidungen Metallsisierungsspalte auch kleiner als 0,3 µm Breite lunkerfrei aufzufüllen. Der genannte Prozeß ist neben der SOG-Planarisierung, die bei einer minimalen Spaltbreite von 0,8 µm ihre Grenze hat, das einzige Verfahren, das enge Spalte mit Abständen bis tief in den Submikrometerbereich lunkerfrei mit gutem lokalen Planarisierungsgrad füllen kann. Die Planarisierungsreichweite beträgt jedoch wiederum nur einige µm.

Darüberhinaus hat sich hinsichtlich der allgemeinen Tauglichkeit der ozonaktivierten CVD-Abscheidung von SiO₂-Schichten herausgestellt, (vgl. K. Fujino, Y. Nishimoto, N. Tokumasu und K. Maeda, VMIC Conf. Proc. 445, 1991), daß aufgrund der festgestellten Abhängigkeit des Abscheidemechanismus von der Oberflächenbeschaffenheit des Substrats Probleme mit der Konformität und der Oberflächenqualität auftreten. Fujino et al stellten zusätzlich fest, daß bei Verwendung von TEOS und noch stärker bei den Verbindungen OMTC (Okta-Methyl-Cyklo-Tetra-Siloxan) und HMDS (Hexa-Methyl-Disiloxan), bei hohen Ozonkonzentrationen (ca. 5 %) auf Si größere Abscheideraten als auf thermischem SiO₂ auftreten. Zur Überwindung dieser störenden Abhängigkeit von der Oberflächenbeschaffenheit schlagen Fujino et al eine Plasmabehandlung der aus thermischem SiO₂ bestehenden Oberflächen vor, um deren Oberflächenbeschaffenheit zu verbessern und um die Abscheiderate auf der modifizierten Schicht zu vergrößern und an diejenige von Si anzugleichen.

Der vorliegenden Erfindung liegt die Aufgabe zugrunde, ein gegenüber den genannten Nachteilen verbessertes Verfahren der eingangs genannten Art anzugeben, das einerseits eine lunkerfreie Auffüllung von Spalten auch kleiner als 0,3 µm erlaubt und gleichzeitig auch bei Abständen zwischen den erhabenen Strukturen bis zum Millimeterbereich einen hohen globalen Planarisierungsgrad gewährleistet.

Diese Aufgabe wird durch ein Verfahren der eingangs genannten Art gelöst,
a) bei dem die Abscheidung ozonaktiviert verläuft und Ausgangssubstanzen verwendet werden, die dabei auf unterschiedlich beschaffenen Oberflächen unterschiedliche Aufwachsraten für SiO₂ zeigen, und
b) bei dem die auf unterschiedlichem Niveau liegenden Oberflächen derart unterschiedlich beschaffen sind oder verändert werden, daß die SiO₂-Schicht auf den höherliegenden Oberflächen langsamer als auf den tieferliegenden aufwächst,
c) und bei dem so lange abgeschieden wird, bis die Oberflächen der schnellwachsenden und der langsamwachsenden Schichtbereiche eine stufenlose, planare Ebene bilden.

Weiterbildungen der Erfindung sind Gegenstand von Unteransprüchen.

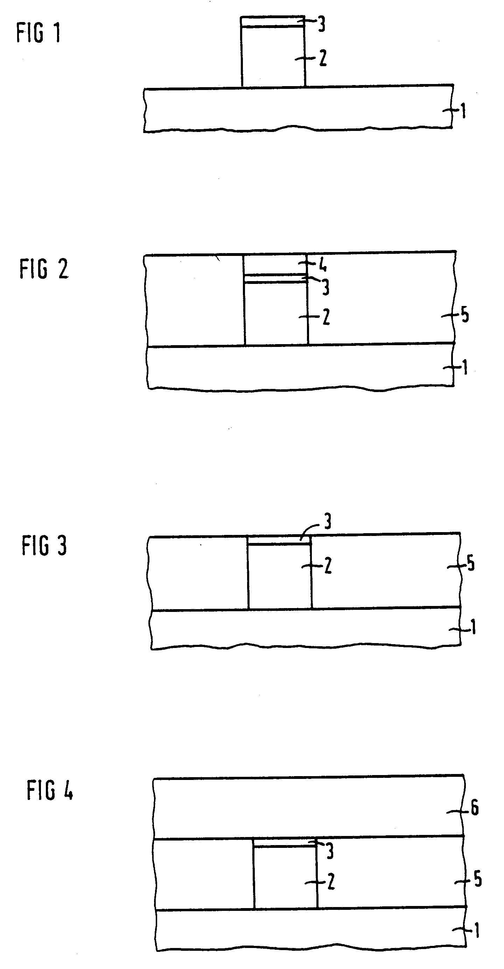

Im folgenden wird die Erfindung anhand eines Ausführungsbeispiels und den Figuren der Zeichnung näher erläutert. Es zeigen
- FIG 1 bis 4: schematisch und im Schnitt Teilschritte von Ausführungsformen des erfindungsgemäßen Verfahrens.

Die Erfindung macht sich die auf unterschiedlichen Oberflächen unterschiedlichen Abscheideraten zunutze, um planare Oberflächen zu bilden. Sie beruht unter anderem darauf, daß die jeweils unterschiedlichen Abscheideraten zwar durch einen Oberflächeneffekt zustandekommen, trotzdem jedoch unabhängig von der Schichtdicke der bereits abgeschiedenen Schicht und der Dauer der Abscheidung sind, wenn die Abscheidung nicht unterbrochen wird. Voraussetzung für die allgemeine praktische Anwendbarkeit der Erfindung ist auch die Erkenntnis, daß einerseits als tieferliegende Startschicht mit schnellerer Aufwachsrate eine Oberfläche in Frage kommt, die an sich schon die gewünschten Eigenschaften zeigt (beispielsweise PECVD-PSG bzw. -BPSG), oder die gezielt mittels einer Plasmabehandlung auf schnelles Schichtwachstum konditioniert wird, daß andererseits jedoch der ozonaktivierte CVD-Prozeß auch auf Plasmaoxid guter Qualität eine ähnlich kleine Abscheiderate wie auf thermischem Oxid zeigt, das wegen der hohen Abscheidetemperatur für die vorliegende Anwendung nicht in Frage kommt. Somit kann auf den Metallisierungsstrukturen eine PECVD-SiO₂-Schicht guter Qualität als Hilfsschicht verwendet werden, um dort ein verlangsamtes Schichtwachstum zu erzielen.

Das erfindungsgemäße Planarisierungsverfahren ist rasterunabhängig, da die Isolierschichten lateral, in engen Spalten genau so schnell wie in breiten, aufwachsen. Dies bedeutet, daß der Planarisierungsgrad auch bei verschieden dicht mit der Metallisierung belegten Bereichen konstant 100 % beträgt. Gegenüber dem vollständig planarisierenden, Dummystrukturen verwendenden Planarisierungsverfahren liegt ein bedeutender Vorteil darin, daß erfindungsgemäß keine zusätzlichen Fotolithographieschritte notwendig sind und daß die Egalisierung der Kanten und Gräben, die bei der Strukturierung der Dummystrukturen entstehen, kein zusätzliches Lack- oder CMP-Planarisierungsverfahren erfordern. Beim erfindungsgemäßen Verfahren werden ähnlich wie bei den bereits bekannten ozonaktivierten Verfahren enge Spalte lunkerfrei mit SiO₂ gefüllt, jedoch bevorzugt vom Spaltboden aus. Das qualitativ hochwertige SiO₂ wächst auf den ausgedehnten, von der Metallisierung nicht bedeckten Gebieten schnell auf, um schließlich mit der gleichzeitig langsam über der Metallisierung wachsenden Schicht eine lokal und global planarisierte Ebene zu bilden.

Als Ausgangssubstanzen für die CVD-Abscheidung sind erfindnungsgemäß insbesondere ONTC, HMDS und andere siliziumorganische Verbindungen geeignet, die auf der Hilfsschicht über dem Metall einen im Vergleich zur Startschicht zwischen dem Metall großen Wachstumsunterschied aufweisen, wobei Wachstumsunterschiede um den Faktor 2 besonders gut ausnutzbar sind. Beim ozonaktivierten CVD-Prozeß bei Atmosphärendruck ist das Verhältnis der Abscheideraten auf Silizium zu SiO₂ bei Verwendung von TEOS als Ausgangssubstanz und hoher Ozonkonzentration ca. 1,5, für HMDS ca. 3 und für OMTC ca. 4.

Typische Prozeßparameter für den planarisierenden ozonaktivierten CVD-Schritt sind:

| | |
|---|---|
| OMTC z. B. mit N₂ gebubbelt (Fluß) | 500 - 4000 sccm |
| Ozon und Sauerstoffluß | 2000 - 10000 sccm |
| Ozonkonzentration im Sauerstoff | 2 - 20 gew.% |
| Druck | 0.1 - 3 bar |
| Temperatur | 300 - 500 °C |
| Abscheiderate auf SiO₂ | 15 - 100 nm/min |
| Abscheiderate auf Phosphorglas (PSG) | 50 - 400 nm/min |

FIG 1 zeigt eine Aluminium-Leiterbahn 2, die auf einer PSG- oder BPSG-Ebene 1 aufgebaut ist und auf die bereits eine Plasmaoxidschicht als Hilfsschicht 3 aufgebracht wurde.

FIG 2, in der wie in allen übrigen Figuren gleiche Bezugszeichen die gleiche Bedeutung wie in FIG 1 haben, zeigt ein Verfahrensstadium, in dem die auf der Schicht 1 schnell aufwachsende SiO₂-Schicht 5 guter Qualität gerade ein durchgehendes, planares Niveau mit der gleichzeitig, aber langsamer aufwachsenden SiO₂-Schicht 4 erreicht hat. Damit ist das grundlegende Ziel einer planarisierenden Abscheidung zunächst erreicht. Es ist bemerkenswert, daß die langsam auf der Hilfsschicht 3 aufwachsende SiO₂-Schicht 4 weniger glatt und homogen als die schnellwachsende SiO₂-Schicht 5 ist.

Die beiden unterschiedlichen, aber planaren SiO₂-Schichtbereiche - über dem Metall und dazwischen - können anschließend zweckmäßigerweise durch einen anisotropen Rückätzschritt, mit einer Ätzselektivität von 1 : 1 bis auf die Metallisierungsebene, oder auch bis mehr oder weniger knapp über der Metallisierung weggeätzt werden, so daß nurmehr das hochwertige SiO₂ zwischen der Metallisierung verbleibt.

FIG 3 zeigt die weiterhin planare Oberfläche nach Durchführung dieses zusätzlichen Verfahrensschrittes.

In FIG 4 ist die Möglichkeit dargestellt, mittels einer zusätzlichen, insbesondere mittels PECVD, auf die planare SiO₂-Schicht abgeschiedenen Schicht 6 die gewünschte Enddicke eines planaren Schichtaufbaus einzustellen. Der in FIG 3 dargestellte Rückätzschritt kann, muß aber nicht vorher erfolgen. Wird beispielsweise eine PSG-Schicht abgeschieden, so kann diese Schicht ohne zusätzliche Oberflächenkonditionierung als Startschicht für die planarisierende ozonaktivierte CVD-Abscheidung der nächsten Metallisierungsebene verwendet werden. Die einzelnen Prozeßschritte des erfindungsgemäßen Verfahrens können vorteilhaft in einer einzigen, gegen die Atmosphäre abgeschlossenen Mehrkammeranlage durchgeführt werden.

## Patentansprüche

1. Verfahren zur lokal und global planarisierenden CVD-Abscheidung von SiO₂-Schichten auf strukturierten Siliziumsubstraten,
a) bei dem die Abscheidung ozonaktiviert verläuft und Ausgangssubstanzen verwendet werden, die dabei auf unterschiedlich beschaffenen Oberflächen unterschiedliche Aufwachsraten für SiO₂ zeigen, und
b) bei dem die auf unterschiedlichem Niveau liegenden Oberflächen derart unterschiedlich beschaffen sind oder verändert werden, daß die SiO₂-Schicht (4, 5) auf den höherliegenden Oberflächen langsamer als auf den tieferliegenden aufwächst,
c) und bei dem so lange abgeschieden wird, bis die Oberflächen der schnellwachsenden (5) und der langsamwachsenden (4) Schichtbereiche eine stufenlose, planare Ebene bilden.

2. Verfahren nach Anspruch 1, bei dem die tieferliegenden Oberflächen aus Phosphorsilikatglas oder Borphosphorsilikatglas bestehen.

3. Verfahren nach Anspruch 1 oder 2, bei dem zur Veränderung der Oberflächenbeschaffenheit mindestens eine Hilfsschicht (3) aufgebracht wird.

4. Verfahren nach Anspruch 3, bei dem auf den höherliegenden Oberflächen als Hilfsschicht (3) eine SiO₂-Schicht im PECVD-Verfahren abgeschieden wird.

5. Verfahren nach einem der Ansprüche 1 bis 4, bei dem die tieferliegenden Oberflächen mittels einer insbesondere in einer Stickstoff-Atmosphäre durchgeführten Plasmabehandlung auf eine größere Aufwachsrate hin konditioniert werden.

6. Verfahren nach Anspruch 5, bei dem eine mittels PECVD abgeschiedene SiO₂-Hilfsschicht durch die Plasmabehandlung konditioniert wird.

7. Verfahren nach einem der Ansprüche 1 bis 6, bei dem die Ausgangssubstanzen aus den Verbindungen TEOS (Tetra-Ethyl-Ortho-Silikat), OMTC (Okta-Methyl-Cyklo-Tetra-Siloxan) oder HMDS (Hexa-Methyl-Disiloxan) ausgewählt wird.

8. Verfahren nach einem der Ansprüche 1 bis 7, bei dem anschließend an die vollständige Planarisierung eine anisotrope Rückätzung der unterschiedlichen SiO₂-Schichtbereiche mit einem Ätzratenverhältnis von 1 : 1 bis zu einem gewünschten Niveau oberhalb der höherliegenden Oberflächen durchgeführt wird.

9. Verfahren nach insbesondere Anspruch 8, bei dem anschließend an die vorherigen Verfahrensschritte mittels einer zusätzlich, insbesondere mittels PECVD, auf die planare SiO₂-Schicht (4, 5) abgeschiedenen Schicht (6) die gewünschte Enddicke eines planaren Schichtaufbaus eingestellt wird.

10. Verfahren nach einem der Ansprüchze 1 bis 9, bei dem die einzelnen Prozeßschritte in einer einzigen, gegen die Atmosphäre abgeschlossenen Mehrkammeranlage durchgeführt werden.

11. Verfahren nach einem der Ansprüche 1 bis 10, bei dem die auf unterschiedlichem Niveau liegenden Oberflächen durch Leiterbahnen (2) und zwischen ihnen befindliche Isolationsschichten gebildet werden.

12. Verfahren nach Anspruch 11, bei dem die planare SiO₂-Schicht (4, 5) oder der planare Schichtaufbau (5, 6) eine Isolierschicht zwischen mehreren Verdrahtungsebenen bildet.

13. Verfahren nach Anspruch 12, bei dem die Schicht (6), bestehend insbesondere aus Phosphorsilikatglas, direkt als schnellwachsender Schichtbereich bei der planarisierenden Abscheidung auf der nächste Verdrahtungsebene verwendet wird.
